# FASCICULE DE BREVET EUROPEEN

(11) **EP 3 256 361 B1**
(45) Date de publication et mention de la délivrance du brevet: **06.05.2020**
(21) Numéro de dépôt: 15725686.8
(22) Date de dépôt: 08.06.2015
(51) Int. Cl.: B61L 23/04, B61K 9/08, G01N 27/20

(54) **DISPOSITIF DE DÉTECTION DE DÉFAUTS DE RAILS PAR MESURE D'IMPÉDANCE**
VORRICHTUNG ZUR ERKENNUNG VON FEHLERN IN SCHIENEN MITTELS MESSUNG DER IMPEDANZ
DEVICE FOR DETECTING FAULTS IN RAILS BY MEASURING IMPEDANCE

(30) Priorité: 13.02.2015 FR 1551217
(43) Date de publication de la demande: 20.12.2017
(73) Titulaire: Metrolab, 75015 Paris (FR)
(72) Inventeur: TÜTZAUER, René, F-75019 Paris (FR); PORE, Jacques, F-93482 Saint Ouen (FR); BURIER, Marc, F-94120 Fontenay-Sous-Bois (FR); PORNIN, Aurélie, F-93482 Saint Ouen (FR); LALLOYER, Frédéric, F-59273 Fretin (FR); COLLARD, Hervé, F-59224 Monchaux Sur Ecaillon (FR)
(74) Mandataire: Lavoix
(86) Numéro de dépôt international: PCT/EP2015/062717
(87) Numéro de publication internationale: WO 2015/118185

(56) Documents cités:
- EP-A1- 2 386 455
- DE-A1-102013 219 763
- US-A- 1 804 380
- US-A- 1 983 442
- US-A- 2 095 911
- US-A1- 2014 129 154
- US-A1- 2014 138 493
- US-A1- 2014 207 317

## Description

La présente invention concerne un dispositif de détection électrique destiné à être porté par un véhicule ferroviaire circulant sur des rails constitutifs d'une voie ferrée et permettant de déceler des défauts dans au moins un rail, lequel dispositif de détection comporte :
- un support de contact propre à être relié mécaniquement au véhicule ferroviaire ;
- au moins un contact de référence et au moins un contact de mesure associés propres à être appliqués sur un rail, et portés par le support ;
- un circuit de traitement auquel sont reliés le ou chaque contact de référence et le ou chaque contact de mesure, propre à la mesure de l'impédance entre les contacts de référence et de mesure associés ;
- des moyens de positionnement du support de contact en regard de la surface du rail suivant une direction de mesure correspondant à l'axe du rail, de sorte que le ou chaque premier contact de référence et le ou chaque contact de mesure associés portent sur le même rail.

Les rails constitutifs des voies ferrées sont soumis à des contraintes mécaniques importantes au cours de leur usage opérationnel dues notamment au passage répété des trains, à la corrosion due à l'environnement, si bien que de tels rails peuvent à terme présenter des défauts structurels, voire être sujet à rupture.

De tels défauts sur des rails peuvent conduire à des difficultés d'exploitation majeures du trafic ferroviaire ou engendrer des conséquences plus graves comme des accidents tels que des déraillements.

Afin de se prémunir de tels désagréments, une maintenance préventive est généralement effectuée sur les rails de voies ferrées de façon à détecter précocement les défauts éventuels que ceux-ci peuvent présenter. Une telle maintenance préventive est effectuée par des moyens divers et allant de la simple observation des conducteurs de véhicules ferroviaires ou d'inspecteurs à pied, jusqu'à l'utilisation de dispositifs embarqués à bord de trains d'inspection dédiés, de type optique ou laser, en passant par l'utilisation de circuits électriques installés sur les voies.

Une technique de détection de défaut de rail donnant de bons résultats est effectuée par mesure de l'impédance des rails. En effet, les rails de voies ferrées sont réalisés en matériaux conducteurs de l'électricité, généralement l'acier et ses dérivés, de sorte qu'ils peuvent être considérés comme un dipôle électrique, et qui par conséquent présente une impédance électrique.

Un rail a donc une impédance électrique qui dépend de la structure du rail, et notamment de sa section.

De fait, la présence d'un défaut sur un rail a pour conséquence de modifier l'impédance électrique de ce rail.

Il existe dans l'état de la technique des véhicules ferroviaires munis de systèmes utilisant la technique de mesure par impédance pour détecter les défauts présents dans des rails.

Par exemple, le document US 4 979 392 décrit un véhicule ferroviaire comportant un dispositif de détection de défauts de rails utilisant la technique de mesure par impédance. Ce dispositif de détection est tracté sur les rails par le véhicule ferroviaire en mouvement, et est propre à déterminer à chaque instant l'impédance de la portion de rails faisant partie du circuit de mesure.

Le dispositif de détection tel qu'il est décrit dans ce document est destiné à être appliqué sur les deux rails constitutifs d'une voie ferrée sur laquelle circule le véhicule ferroviaire. Ainsi, ce dispositif est propre à mesurer à un instant donné l'impédance de la portion des deux rails située entre l'extrémité du véhicule ferroviaire et le dispositif de détection.

Un véhicule ferroviaire muni d'un tel dispositif de détection ne donne pas entière satisfaction. En effet, l'impédance électrique mesurée par le dispositif de détection ne permet pas de caractériser un défaut mais seulement de détecter l'existence d'une rupture sur l'un des deux rails.

US 1 983 442 et US 2014/138 493 décrivent d'autres dispositifs de détection électrique de défauts de l'état de la technique.

Un but de l'invention est de fournir un dispositif de détection de défauts de rails par mesure d'impédance permettant de caractériser précisément le défaut.

A cet effet, l'invention a pour objet un dispositif du type précité, caractérisé en ce que :
- il comporte au moins deux contacts de mesure décalés transversalement par rapport à la direction de mesure ; et
- le circuit de traitement comporte des moyens de mesure de l'impédance entre au moins un contact de référence et chaque contact de mesure.

La présente invention comprend tous les éléments nécessaires pour une caractérisation automatisée et précise des défauts de surface du rail. Elle permet ainsi de diminuer le besoin d'intervention humaine. La détection et la caractérisation des défauts de surface du rail est réalisée en un seul dispositif. Ce dispositif peut être monté sur tous les types de trains circulant sur la ligne, permettant ainsi une surveillance quasi-permanente et automatique des rails, pour anticiper les interventions de remise à niveau. La probabilité de rupture de rails est très significativement réduite. Le dispositif est aussi capable de détecter des ruptures franches du rail qui se seraient développées trop rapidement pour être reconnues à temps, pour permettre une mise en sécurité immédiate de l'exploitation jusqu'à la réparation du rail.

Le dispositif de détection selon l'invention peut comprendre l'une ou plusieurs des caractéristiques suivantes :
- les nombres de contacts de référence et de contacts de mesure sont différents ;
- ledit dispositif comporte des moyens d'application des contacts sur le rail selon des angles d'application différents les uns des autres dans le plan transversal à la longueur du rail ;
- le support de contact est propre à s'appliquer sur la surface du rail et porte plusieurs contacts isolés électriquement les uns des autres et chargés élastiquement à l'écart du support portant chaque élément de contact ;
- les contacts d'un même support sont reliés entre eux pour former une chaînette articulée, retenue à ses extrémités au support et s'étendant transversalement à la direction de mesure ;
- ledit dispositif comporte plusieurs lames adjacentes isolées entre elles, chacune formant un contact, lesquelles lames sont guidées en coulissement les unes par rapport aux autres ;
- le support comportant une surface d'appui sur un flanc latéral du rail et le dispositif comporte des moyens de sollicitation latérale du support pour maintenir la surface d'appui en contact avec le flanc latéral du rail ;
- ledit dispositif comporte un système de localisation du véhicule et des moyens de corrélation des mesures avec la position du véhicule lors de la mesure ;
- ledit dispositif comporte des moyens de caractérisation des défauts à partir d'au moins deux caractéristiques d'impédance mesurées par les au moins deux contacts de mesure ;
- le ou chaque contact comporte, à chacune de ses extrémités une forme chanfreinée ;

L'invention a en outre pour objet un véhicule comportant des roues propre à rouler sur la voie ferrée, caractérisé en ce qu'il comporte un dispositif tel que défini précédemment et le ou chaque contact de référence et le ou chaque contact de mesure associés sont disposés entre deux roues immédiatement successives supportant la voiture.

Elle a également pour objet une machine de mesure comportant un chariot auto-moteur automatique et/ou télécommandé propre à suivre au moins une file de rails et un dispositif tel que défini précédemment, solidarisé au chariot auto-moteur.

L'invention a enfin pour objet un procédé de détection de défauts portés par des rails constitutifs d'une voie ferrée, caractérisé en ce qu'il comporte l'étape de mesure de l'impédance du rail entre au moins un contact de référence et au moins deux contacts de mesure décalés transversalement par rapport à la direction principale du rail, les contacts circulant suivant la longueur du rail.

Suivant des modes particuliers de mise en œuvre, le procédé prévoit :
- le déplacement du dispositif le long des rails s'effectue à la vitesse normale d'exploitation d'un train, et
- l'analyse des mesures fournies par les contacts de mesure s'effectue en temps réel.

L'invention sera mieux comprise à l'aide de la description qui va suivre, donnée uniquement à titre d'exemple, et faite en se référant aux dessins annexés, sur lesquels :
- la figure 1 est une vue schématique d'un véhicule ferroviaire muni d'un dispositif de détection de défauts disposés sur des rails ;
- la figure 2 est une vue schématique fonctionnelle du dispositif de détection de défauts de rails ;
- la figure 3 est une vue schématique du circuit de détection de défaut présentant deux contacts de mesure sur un rail ;
- la figure 4 est une variante du schéma 3, en utilisant un seul générateur de fréquence et trois contacts de mesure ;
- la figure 5 un ensemble de trois graphes représentant l'allure de relevés de mesure d'impédance d'un même défaut d'un rail depuis trois contacts de mesure répartis transversalement suivant la largeur du rail ;
- les figures 6 et 7 sont des vues schématiques de coté de deux modes de réalisation d'un caisson de mesure comportant plusieurs contacts de mesure mobiles portant sur des points décalés de la section du rail ;
- les figures 8 à 10 d'une part et les figures 11 à 13 d'autre part sont des vues en section suivant les plans A-A, B-B et C-C respectivement de deux modes de réalisation de l'agencement des éléments de contact de la figure 7 ;
- la figure 14 est une vue en section d'un contact selon un mode de réalisation ;
- la figure 15 est une vue en section d'un patin de mesure comportant plusieurs contacts articulés entre eux ;
- la figure 16 est une vue en perspective de trois quarts de dessus d'un patin de mesure suivant encore un mode de réalisation en contact avec le rail ;
- la figure 17 est une vue en perspective de trois quarts de dessous du patin de mesure de la figure 16 ; et
- la figure 18 est une vue en coupe d'une variante de réalisation des contacts d'un patin de mesure dans plusieurs positions.

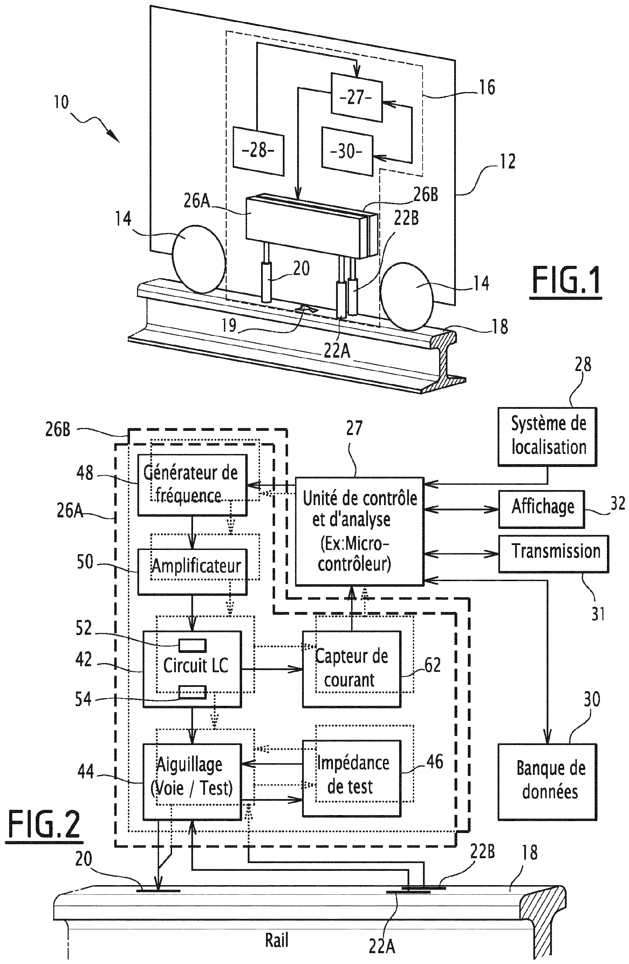

Comme représenté sur la figure 1, un véhicule ferroviaire 10 comporte au moins une voiture 12 portée par des roues 14 et au moins un dispositif 16 de détection électrique de défauts portés par un unique rail 18 d'une voie sur laquelle circule le véhicule.

Le dispositif de détection électrique 16 est solidaire de la voiture 12 du véhicule ferroviaire 10, et avantageusement est situé partiellement dans la caisse du véhicule ferroviaire et sur le bogie de support.

Le dispositif de détection 16 établit un circuit électrique de mesure comprenant le rail.

Un tel dispositif de détection électrique 16 est apte à déceler des défauts 19 portés par le rail 18 par la technique de mesure d'impédance comme décrite ci-dessous.

Le dispositif de détection électrique 16 comporte au moins un contact de référence 20 et au moins deux contacts de mesure 22A, 22B décalés suivant la largeur du rail, ainsi qu'autant de blocs de traitement 26A, 26B, ... que de contacts de mesure 22A, 22B, auxquels ils sont reliés. Il comporte une unité de contrôle et d'analyse 27, un module 28 de géolocalisation du lieu de mesure de l'impédance et une mémoire 30.

Le contact de référence 20 est un contact électrique fournissant un potentiel de référence commun à l'ensemble des blocs de traitement 26A, 26B.

Les contacts 20 et 22A, 22B sont propres à prendre appui sur le même rail 18 à distance l'un de l'autre et à glisser sur sa surface supérieure ou éventuellement latérale lors de l'avancement du véhicule. Le contact de référence 20 d'une part et les contacts de mesure 22A, 22B d'autre part sont disposés à des positions longitudinales successives suivant la direction d'avancement constituant la direction de mesure. En variante, ils sont disposés côte à côte suivant une même section du rail. Les contacts de mesure 22A, 22B sont espacés entre eux d'au moins 1 cm. Les contacts de référence 20 et mesure 22A, 22B sont portés de préférence par un même bogie et sont disposés de sorte qu'aucune roue ne se situe entre eux.

Les contacts de mesure 22A, 22B sont décalés transversalement par rapport à la direction de mesure, c'est-à-dire qu'ils sont à des emplacements différents en projection sur la section du rail suivant la direction de mesure, afin de pouvoir localiser des défauts de façon différenciée en fonction de leur position sur la surface du rail.

Le schéma fonctionnel figure 2 explique l'interaction des différents éléments du dispositif de détection électrique 16.

Chaque bloc de traitement 26A, 26B est intégré dans un circuit de mesure séparé comportant le rail 18 et des éléments du dispositif de détection.

Chaque circuit de mesure forme un circuit RLC et consiste en : le contact de référence 20, un des contacts de mesure 22A, 22B, le tronçon de rail 18 situé entre le contact de référence et ledit contact de mesure, un circuit LC noté 42, comprenant une inductance et une capacité. Chaque circuit LC 42 augmenté de la résistance R du rail 18 est ajusté pour être en résonance à la fréquence générée par le générateur 48.

Les blocs de traitement 26A, 26B sont de structures identiques et ne varient que par les valeurs de certains composants.

Pour chaque circuit, le bloc de traitement 26A, 26B comporte des moyens de commutation 44 interposés entre les contacts de référence 20 et de mesure 22 et chaque circuit LC 42. Ils sont propres à assurer la connexion sélective du circuit LC 42 soit aux contacts 20, 22A, 22B soit à une impédance de test 46 du bloc de traitement 26A ou 26B. Avantageusement, les moyens de commutation 44 sont un inverseur électrique commandable par l'utilisateur, ou programmable pour effectuer un calibrage périodique en fonctionnement automatique.

Chaque bloc de traitement 26A, 26B comporte un générateur de fréquence 48 relié au circuit LC 42 au travers d'un amplificateur de courant 50 pour l'alimentation du circuit RLC.

Chaque générateur de fréquence 48 est apte à délivrer un courant alternatif modulé selon une fréquence qui lui est propre. Les fréquences des différents générateurs 48 sont identiques ou différentes les unes des autres suivant le bloc de traitement 26A, 26B.

L'amplificateur de courant 50 est apte à amplifier le courant électrique issu du générateur de fréquence 48 de sorte que l'intensité de ce courant soit adaptée à une détection optimale.

Chaque circuit LC 42 comporte un transformateur 52 et au moins un condensateur 54. Avantageusement, le transformateur 52 est un transformateur de rapport 1 pour 1. L'inductance du bobinage de transformateur 52 est réglable par l'utilisateur du dispositif de détection, de même que la capacité de chaque condensateur 54.

Chaque bloc de traitement 26A, 26B est relié à l'unité de contrôle 27 apte à piloter chaque générateur de fréquence 48. Il s'agit par exemple d'un microcontrôleur.

La fréquence de chaque générateur est fixée sous la commande de l'unité 27 pour être, lorsque le circuit LC 42 est relié à l'impédance de test 46, la fréquence de résonance de chacun des circuits résonants RLC ainsi formés.

Chaque impédance de test 46 est un dipôle électrique présentant une impédance électrique strictement égale à l'impédance d'un rail 18 inspecté ne présentant aucun défaut. L'impédance de test 46 permet de calibrer les éléments de réglage du circuit LC 42, et plus particulièrement la valeur de l'inductance du transformateur 52 et de la capacité des condensateurs 54.

L'impédance de test 46 est par exemple une résistance électrique.

Elle est en variante commune à plusieurs des blocs de traitement 26A, 26B.

Chaque bloc de traitement 26A, 26B comporte enfin un capteur de courant 62 apte à mesurer l'amplitude du courant alternatif sinusoïdal circulant dans le circuit résonnant RLC formé du circuit LC 42 et du rail 18 entre une paire de contacts 20, 22A, 22B associés, ou dans l'impédance de test 46.

Le capteur de courant 62 est par exemple réalisé au moyen d'une résistance électrique, aux bornes de laquelle la tension est mesurée.

Chaque capteur de courant 62 est relié en entrée à l'unité de contrôle 27.

L'intensité ainsi mesurée est représentative de l'impédance du circuit qui intègre le tronçon de rail entre les deux contacts 20 et 22A ou 22B. Cette impédance dépend elle-même de la présence ou non d'un défaut sur le tronçon de rail. La variation de l'impédance du circuit permet ensuite non seulement de détecter la présence ou non d'un défaut mais contribue aussi à sa caractérisation, en combinaison avec les impédances mesurées par les capteurs de mesure complémentaires décalés transversalement.

L'unité de contrôle 27 est propre à traiter, à intervalles d'échantillonnage réguliers, les mesures d'impédance relevées par les capteurs de courant 62.

L'unité de contrôle 27 comporte des moyens de traitement du signal pour déterminer, à partir de l'amplitude des courants reçus au cours du temps et donc de l'avancement du véhicule, si la portion de rail analysé est en défaut, par analyse des impédances mesurées à chaque instant sur au moins deux endroits sur le rail définis par au moins deux capteurs de mesure 22A, 22B décalés transversalement.

Le traitement du signal consiste en particulier en un filtre passe-bas, par exemple qui laisse passer les fréquences sur une bande comprise entre 1 Hz et 100 000 Hz et atténue les autres.

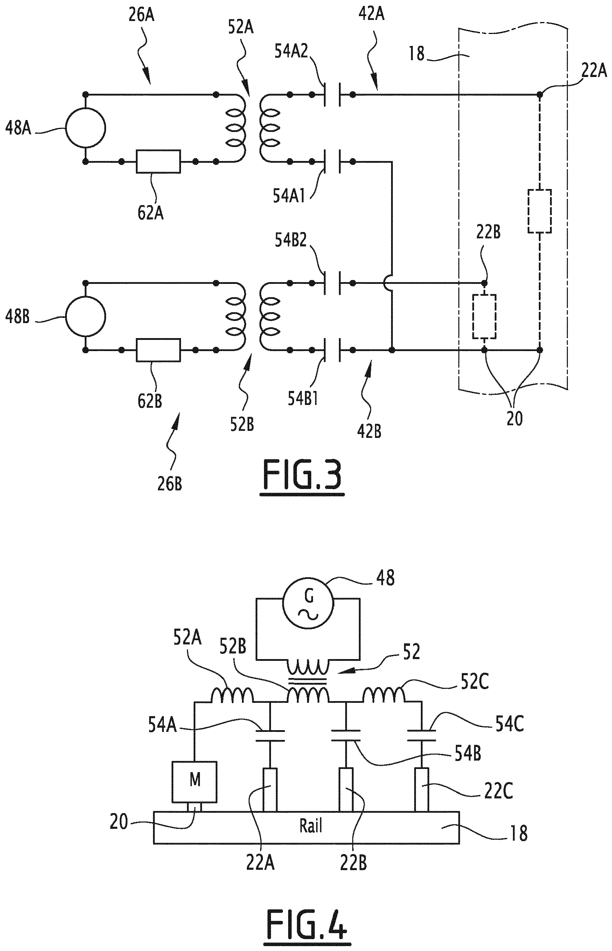

Dans le mode de réalisation de la figure 3, les blocs de traitement 26A, 26B comportent chacun un circuit LC noté respectivement 42A, 42B correspondant chacun à un contact de référence commun 20 et à un contact de mesure propre 22A, 22B. Ces contacts de mesure sont affectés chacun à un bloc de traitement 26.

Chaque circuit LC 42A, 42B comporte un générateur de fréquence propre noté 48A, 48B respectivement et incorporant un amplificateur 50 non représenté.

Chaque générateur de fréquence 48A, 48B est relié au primaire d'un transformateur noté 52A, 52B. Des résistances de mesure, aux bornes desquelles la tension est mesurée, forment les capteurs de courant 62A, 62B pour chaque circuit LC 42A, 42B.

Des condensateurs 54A1, 54A2 et 54B1, 54B2 sont disposés entre les deux bornes du secondaire du transformateur 52A, 52B respectivement et le contact de référence 20, d'une part, et le contact de mesure correspondant 22A, 22B, d'autre part.

Avantageusement, un seul contact de référence 20 est utilisé pour les deux circuits LC 42A, 42B.

Sur cette figure, l'impédance du rail 18 entre les contacts 20 d'une part et 22A et 22B d'autre part est illustrée en pointillés.

Chaque générateur 48A, 48B génère un signal sinusoïdal à une fréquence pour laquelle l'impédance du circuit RLC est ajustée à son minimum

Par la suite, lorsque l'impédance varie, sa transformée au primaire du transformateur et, par conséquent, l'amplitude du courant au primaire du circuit varient également. La valeur RMS de ce courant est mesurée par les capteurs 62A, 62B et forme ainsi une image de l'impédance.

Même si les circuits de mesure présentent un point commun, ils sont indépendants. Il est donc possible de générer une fréquence identique depuis les deux générateurs 48A, 48B.

Ce schéma est reproductible sur un ensemble de plus de deux contacts de mesure et blocs de traitement et non pas seulement sur deux tels que représentés dans le schéma de la figure 3.

En alternative aux valeurs RMS, les données de mesure sont des données brutes.

Suivant un autre mode de réalisation, le dispositif illustré sur la figure 4 comporte trois contacts de mesure notés 22A, 22B, 22C. Un condensateur respectivement 54A, 54B, 54C est relié entre chaque contact de mesure 22A, 22B, 22C et à un bobinage secondaire propre noté 52A, 52B, 52C d'un même transformateur 52. Le contact de référence 20 est relié à une extrémité du bobinage secondaire.

L'ensemble des circuits LC ainsi formés est alimenté par le même générateur 48 dont les bornes sont reliées au primaire du transformateur 52. Chaque condensateur en série avec un bobinage secondaire du transformateur forme un circuit LC propre dont la fréquence de résonance avec la résistance de test 46 (non représentée) montée en série coïncide avec la fréquence générée par le générateur de fréquence 48.

Les moyens de mesure de l'amplitude du courant dans chaque circuit LC ne sont pas représentés sur cette figure.

L'analyse du signal repose sur les variations des impédances révélées par le courant circulant dans le rail en des points décalés longitudinalement, à savoir le contact de référence 20 et le contact de mesure 22.

La caractérisation du défaut résulte de la combinaison des différentes variations constatées entre le contact de référence 20 et chacun des contacts de mesure 22A, 22B, 22 C, ces derniers étant décalés transversalement suivant la largeur du rail.

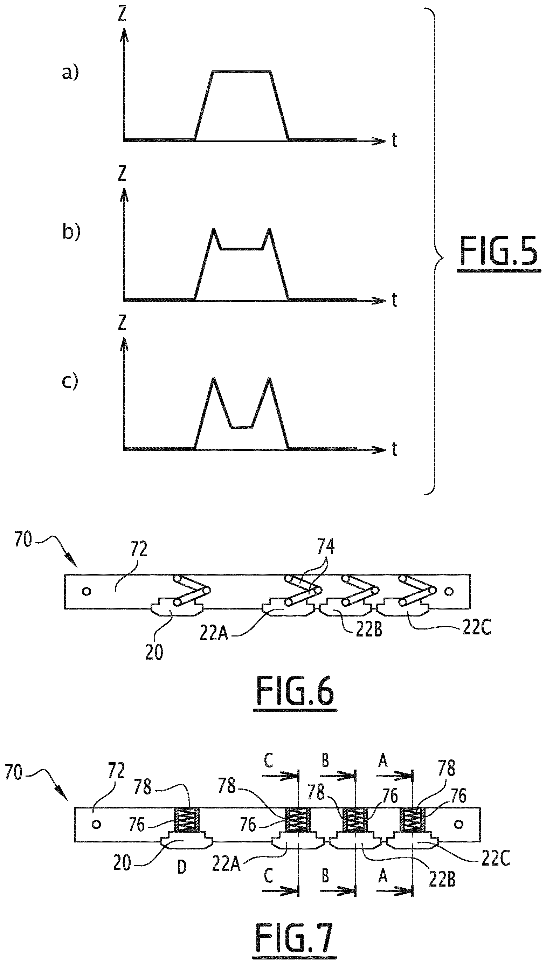

Des variations d'impédance en fonction du temps, c'est-à-dire du déplacement des contacts sur les rails, sont illustrées sur la figure 5 pour trois contacts de mesure 22A, 22B, 22C décalés transversalement suivant la largeur du rail, en portant sur un même défaut. Les contacts de mesure 22 sont supposés positionnés en des emplacements répartis suivant la largeur du rail.

Le logiciel de caractérisation des défauts est programmé de manière à différencier si les signatures a), b) et c) correspondent à un seul et unique défaut, ou s'il s'agit de défauts adjacents, répartis transversalement sur le rail au même endroit.

De préférence, la mémoire 30 contient des signatures préenregistrées de différents types de défaut de rail et l'unité de contrôle 27 est propre à comparer les profils d'impédance relevés depuis plusieurs contacts de mesure décalés transversalement aux signatures préenregistrées pour déterminer le type de défaut probable, ainsi que sa taille.

Les signatures mémorisées dans la mémoire 30 contiennent chacune plusieurs profils, correspondant à l'ensemble des mesures obtenues depuis chacun des contacts de mesure décalés transversalement pour un même défaut.

Ainsi, comme l'allure des courbes d'impédance relevées est spécifique à chaque défaut, la technique de détection par mesure d'impédance d'un rail permet de connaitre précisément les caractéristiques d'un défaut, comme son type, sa forme, ou sa taille.

De manière générale, plus la surface du rail est régulière, plus l'impédance est faible. L'augmentation d'impédance traduit une discontinuité ou un défaut à la surface du rail.

En cas de défaut de surface, lorsque l'un ou l'autre des contacts de mesure passe sur le défaut la surface, la qualité du contact électrique diminue et l'impédance augmente
Les profils 5a, 5b et 5c de la figure 5 correspondent à chacun des relevés de chacun des trois contacts de mesure, respectivement 22A, 22B et 22C portant sur un même défaut localisé sur tout ou une partie de la table de roulement du rail. Dans le cas représenté, le défaut est très prononcé à l'endroit de passage du capteur 22A (5a), et de plus en plus atténué à l'endroit de passage des capteurs 22B (5b) et 22C (5c). Le défaut s'étend donc des endroits de passage du contact 22A en s'atténuant jusqu'à 22C, ce qui permet de déduire sa taille et sa forme.

Dans un autre exemple non représenté, si tous les trois contacts 22A, B et C couvraient toute la surface du rail, et présentaient la même signature correspondant au profil 5a au même instant T pour la même portion de rail et donc portant sur un même défaut, on en déduirait une rupture franche du rail.

La connaissance du défaut, en plusieurs emplacements de la section du rail, permet de déterminer la taille et la forme et ainsi la nature exacte du défaut. En effet, pour chaque emplacement dans la section du rail, l'étendue du défaut est mesurée suivant sa longueur sur le rail, et sa profondeur peut être estimée en fonction de la variation des impédances. L'existence de plusieurs mesures localisées transversalement sur le rail sur un même défaut permet d'obtenir une information sur la nature du défaut et ainsi de le caractériser ; tandis qu'un seul contact de mesure ne permet de déceler que la seule présence d'un défaut (sans aucune information de plus) ; et peut même ne pas détecter le défaut si l'endroit de passage de l'unique contact se situe à côté du défaut.

Le module de géolocalisation 28 est apte à localiser le véhicule ferroviaire 10 à tout instant sur la voie ferrée. Le module de géolocalisation 28 est par exemple réalisé au moyen d'un système GPS, et/ou d'un détecteur de balises situées à intervalles réguliers sur la voie ferrée, et du système odométrique du train 10. Le système odométrique fournit en outre la vitesse du train, nécessaire pour calculer la longueur et la forme du défaut de rail sur la base de la durée de perturbation de l'impédance représentée par des profils de type des profils 5a à 5c, pendant que le train avance. Il est relié à l'unité de contrôle 27 pour permettre une localisation et une caractérisation de chaque mesure effectuée.

L'unité de contrôle 27 est propre, lorsqu'un défaut est repéré, à assurer une corrélation temporelle entre les données de géolocalisation issues du module de géolocalisation 28 et les valeurs issues du bloc de traitement en aval 26A, 26B, etc. Cette unité de contrôle 27 est formée par une unité informatique, par exemple un ordinateur portable ou une armoire électronique, avec des logiciels adaptés. Elle est propre à assurer, en continu, un filtrage, un post-traitement comportant l'intégration des données fournies par les différents circuits de mesure aboutissant à la caractérisation du défaut dont notamment sa taille et son volume.

Une banque de données 30 est reliée à l'unité de contrôle 27. Elle contient les éléments nécessaires à l'unité de contrôle 27 pour réaliser l'opération de caractérisation des défauts. Elle stocke également les résultats des traitements de l'unité de contrôle 27 au fur et à mesure de leur production.

En variante, l'unité de contrôle 27 est propre à générer une alarme en temps réel si le dépassement d'un seuil prédéfini de gravité des défauts est constaté sur un ou plusieurs résultats.

Avantageusement, l'alarme comporte plusieurs seuils de gravité, définissant par exemple les défauts de rails à inspecter plus en détail, les défauts de rails à réparer dans une période donnée par exemple quarante-huit heures ou vingt-quatre heures ou encore les défauts de rails nécessitant une réduction de la vitesse des trains voire un arrêt de l'exploitation.

L'unité de contrôle 27 est interfacée avec une unité de transmission 31 qui transmet ces informations de caractérisation des défauts détectés à un établissement fixe, cette transmission pouvant être effectuée en temps réel ou en temps différé.

En variante, l'unité de contrôle 27 est interfacée avec une unité d'affichage 32 embarquée permettant au personnel de prendre connaissance de la caractérisation des défauts détectés.

Le dispositif de détection à mesure d'impédance est embarqué à bord d'un train et ce train circule en ligne en fonction de la stratégie de maintenance préventive. Le nombre de trains équipés et la fréquence de mesure sera établie en fonction des exigences de la stratégie de maintenance, cette dernière étant soumise, entre autres, au programme d'exploitation (intensité de circulation et charge des trains), aux types de rail (un rail léger peut être sur-sollicité en circulation exceptionnelle répétée), et à la répartition entre maintenance préventive et corrective décidée par le mainteneur.

Pour la mise en oeuvre des contacts de référence 20 et de mesure 22A, 22B, 22C, ceux-ci sont avantageusement portés dans un caisson 70 en forme de poutre 72 sur lequel les contacts sont articulés comme illustré sur la figure 6.

Les contacts sont isolés électriquement les uns des autres et de la poutre 72.

Dans ce mode de réalisation, un unique contact de référence 20 est monté à une extrémité du caisson 70. Il prend appui sur toute la largeur du rail. Le caisson 70 comporte plusieurs contacts de mesure 22A ,22B, 22C, ici trois, disposés successivement et prenant appui sur des plages transversales différentes à la surface du rail. Par exemple, le contact 22A prend appui sur la partie médiane du rail, le contact 22C sur le congé intérieur du rail et le contact 22 B entre les deux contacts 22A et 22C suivant la largeur du rail.

Le caisson 70 est avantageusement suspendu aux boîtes d'essieu d'un bogie par des bras articulés et des moyens de suspension réglables. Ainsi, la compensation des débattements de la suspension primaire du bogie n'est pas nécessaire et le caisson 70 reste à distance sensiblement constante de la surface du rail. Des butées d'arrêt du caisson 70 sont avantageusement prévues entre le bogie et le caisson pour assurer son guidage.

Les contacts successifs sont de préférence montés de manière articulée par rapport à la poutre 72 pour être correctement appliqués au rail. Ce montage s'effectue par exemple par un ensemble de biellettes 74 formant pour chaque contact un pantographe. De préférence, les contacts sont maintenus au contact du rail par un moyen élastique disposé entre chaque contact et le caisson 70.

Dans le mode de réalisation de la figure 7, les contacts 20, 22A, 22B et 22C sont montés déplaçables en translation par rapport au caisson dans le plan de la section du rail. Ils sont guidés en translation dans une gaine 76. Un ressort 78 est interposé entre chaque contact et la poutre 72 pour solliciter le contact mobile contre le rail.

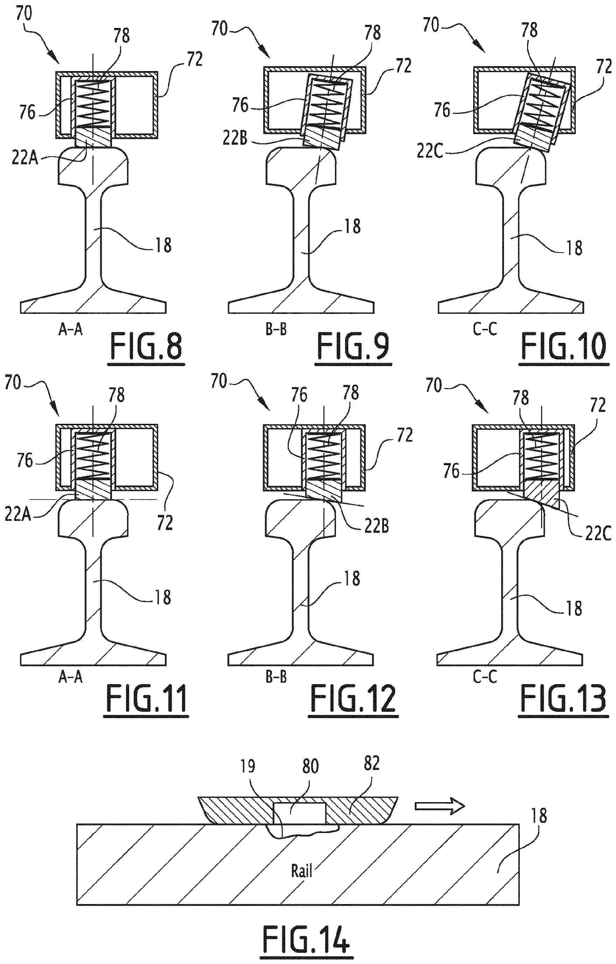

Dans le mode de réalisation des figures 8 à 10, la surface de contact de chaque patin est perpendiculaire à l'axe de déplacement du patin dans la gaine 76. En fonction de la forme nominale du rail, et en fonction de la position transversale du contact par rapport au rail, l'angle mesuré par rapport à la verticale de l'axe de coulissement du contact par rapport au caisson est variable. Il est d'autant plus élevé que le contact est proche du flanc du rail.

Dans le mode de réalisation des figures 11 à 13, l'axe de déplacement est identique pour tous les contacts mais la surface de chaque patin présente une inclinaison propre par rapport à l'horizontale. L'angle de chaque surface de contact par rapport à l'horizontale est d'autant plus grand que le contact est proche du flanc du rail.

En variante, à la fois les axes de coulissement et les inclinaisons des surfaces de contact par rapport aux axes de coulissement sont distincts d'un contact à l'autre suivant la position du contact dans la largeur du rail.

Les contacts sont avantageusement chanfreinés à leurs extrémités avant et arrière en considérant le sens d'avancement du véhicule pour pouvoir passer des aiguillages et autres appareils de voie sans les accrocher.

Comme illustré sur la figure 14, chaque contact comporte avantageusement un noyau métallique conducteur de l'électricité 80 en contact avec le rail et un enrobage latéral 82 en matériau isolant dans lequel le noyau est logé tout en affleurant à la surface inférieure en contact avec le rail. L'enrobage 82 a avantageusement une forme de ski avec deux spatules d'extrémité. En variante, il est simplement chanfreiné. Cette solution présente l'avantage supplémentaire de permettre un contact de taille suffisamment petite pour ne pas shunter de petits défauts de rail. La surface de contact du noyau avec le rail est alors comprise entre 0,05 cm² et 2 cm².

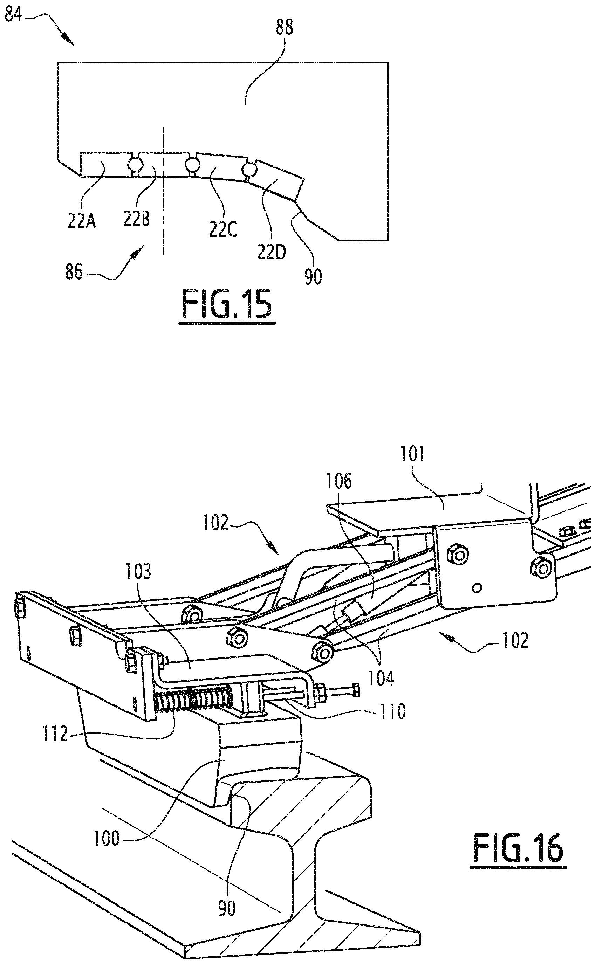

Dans le mode de réalisation de la figure 15, un patin, noté 84 appliqué sur le rail porte plusieurs contacts de mesure 22A, 22B, 22C, 22D adjacents disposés dans un même plan transversal au rail. Ces contacts sont reliés entre eux pour former une chaînette articulée 86, retenue à ses extrémités à un support 88 maintenu en regard de la surface supérieure du rail et appliqué sur le rail par une force élastique verticale. Cette chaînette s'étend transversalement à la direction principale du rail formant la direction de mesure. Les contacts sont isolés électriquement les uns des autres au niveau des articulations prévues entre eux. La chaînette épouse la forme du rail lorsque les contacts sont appliqués contre le rail.

Dans ce mode de réalisation, notamment, le support 88 comporte avantageusement un chanfrein 90 illustré sur la figure 15 propre à prendre appui sur le congé du rail, et à y être maintenu par un organe élastique appliquant une force de pression sensiblement horizontale sur le support pour maintenir le chanfrein 90 contre le congé en plus de la force verticale appliquée sur le support.

Quel que soit le mode de réalisation, la longueur du patin correspond à la plus grande lacune de cœur d'aiguillage à franchir. Par exemple, pour un frotteur à application horizontale sur le rail, la longueur du patin sera ainsi de 850 mm environ, chanfreins inclus, dans l'exemple d'un métro de grande capacité. Cette longueur est de préférence comprise entre 700 mm et 1000 mm.

Des chanfreins sont aménagés aux extrémités du patin pour aborder les défauts de rail ainsi que les appareils de voie. En outre, ces chanfreins présentent une forme de déflecteur pour renvoyer le graissage éventuel du rail vers le bas, en évitant une remontée de la graisse qui affecterait la capacité de freinage du train.

Sur la figure 16 est représenté un exemple de montage d'un patin unique noté 100 sur une platine 101 de fixation au longeron de la structure d'un bogie.

Le patin est retenu par deux parallélogrammes déformables 102 adjacents constituées de bielles 104 assemblées pour assurer le guidage du patin 100 sur le rail, en compensant le débattement de la suspension primaire du bogie.

Cet aménagement est de préférence prévu sous chacun des deux longerons du bogie, ce qui correspond à un dispositif de chaque côté pour détecter les défauts des deux rails de la voie.

Les deux parallélogrammes 102 sont solidarisés d'un coté sur le bogie et de l'autre sur une platine 103 portant le patin 100. Les parallélogrammes 102 s'étendent dans des plans perpendiculaires au rail.

Un vérin 106 est prévu au niveau des bielles de guidage. Il est interposé entre le patin 100 et la platine 101 solidaire du bogie. Ce vérin 106 agit verticalement sur le patin en plus de son propre poids pour appliquer le patin contre la surface du rail.

La platine 103 est retenue parallèle à la surface supérieure du rail. Le patin 100 est monté coulissant sous la platine 103 par des glissières 110 disposées perpendiculairement à la longueur patin dans le plan de la platine 103. Des organes élastiques 112 interposés entre la platine 103 et le patin 100 assurent une application transversale du patin contre le congé du rail, de sorte que le chanfrein 90 formant une surface d'appui transversale soit maintenu contre le congé du rail.

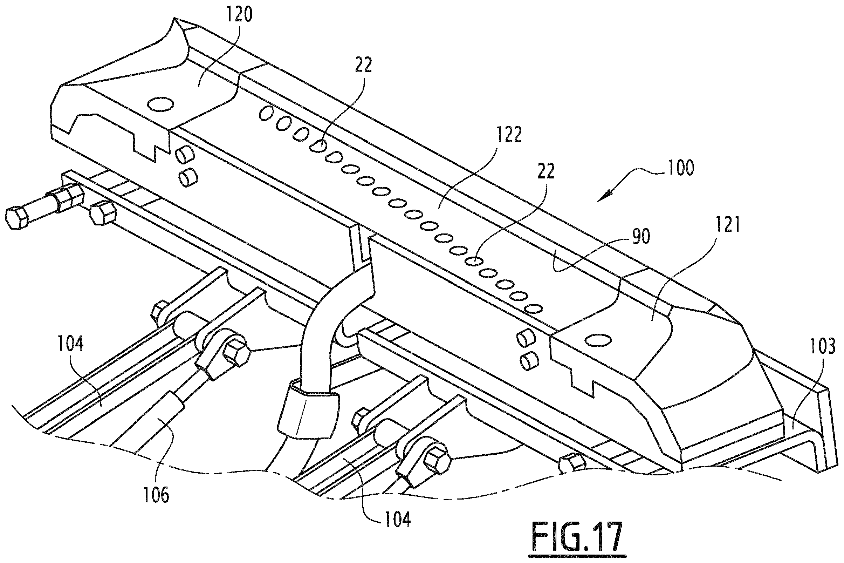

Comme visible sur la figure 17, le patin comporte un unique contact de référence formé par un embout amovible 120 prévu en tête du patin. Cet embout s'appuie sur la surface du rail sur toute la largeur du rail. Ce contact de référence est avantageusement dupliqué en utilisant le deuxième embout 121 du frotteur.

En variante, le contact de référence est formé par la surface médiane même du patin notée 122, laquelle est maintenue en contact du rail. Les contacts de mesure 22 sont isolés du contact de référence.

Un grand nombre de contacts de mesure 22, ici au nombre de 18 et de préférence avec un nombre compris entre 10 et 30 sont disposés suivant la largeur du patin. Ils sont chacun indépendants et appliqués élastiquement sur le rail depuis le support du patin. Ils présentent chacun un chanfrein pour être capable de passer sur les défauts sans danger d'être cisaillés (chanfreins non représenté) et sont isolés électriquement les uns des autres et du corps du patin.

Ces contacts sont décalés les uns par rapport aux autres longitudinalement et transversalement pour former un alignement couvrant le champignon du rail.

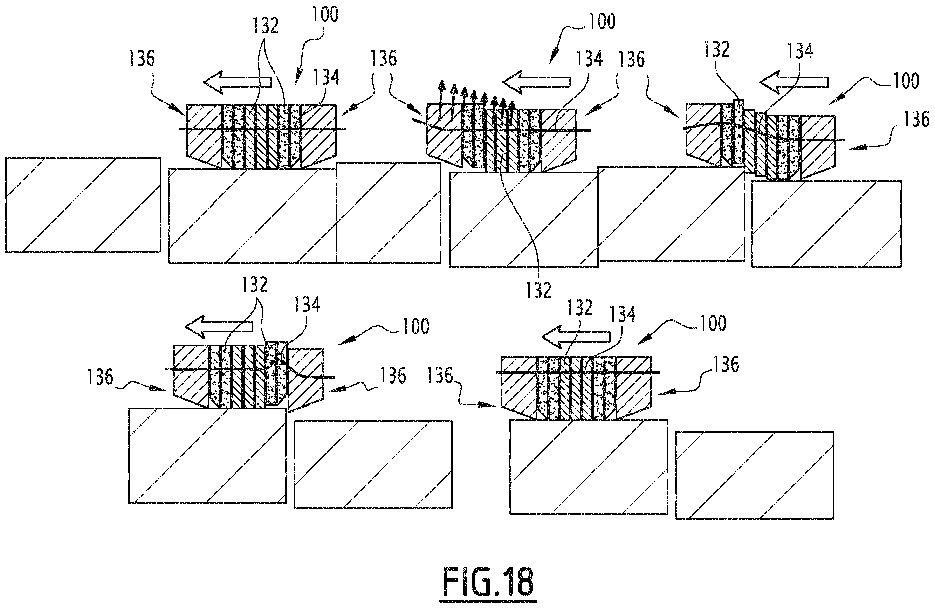

La figure 18 illustre un même patin 100 avec une autre conception de contacts dans plusieurs positions différentes lors du franchissement d'un épaulement entre deux rails successifs.

Ce patin comporte plusieurs lames adjacentes 132, chacune formant un contact 22A, 22B, 22C etc. Ces lames sont guidées en coulissement les unes par rapport aux autres en étant maintenues en contact les unes contre les autres. Elles sont isolées électriquement entre elles par un revêtement isolant. Un bloc de guidage avant et arrière assure que les imperfections et défauts du rail sont correctement abordées pas les lames ; dans le présent exemple, ces blocs servent aussi de contacts de référence 20 (dupliqués).

Les lames sont coulissantes verticalement et sont retenues ensemble et avec les blocs de guidage par un ou plusieurs torons 134 en matériau élastomère traversant longitudinalement l'empilement de lames adjacentes.

Chaque lame comporte en regard de la surface du rail une excroissance propre à prendre appui sur la surface du rail. Les excroissances réalisent les contacts électriques avec le rail. Ces excroissances sont en des emplacements différents suivant la largeur du rail pour toutes les lames.

Le toron 134 assure un entraînement mutuel des lames adjacentes pour ne pas accrocher les défauts de rail et pour franchir d'éventuelles irrégularités du rail. Contrairement à la réalisation précédente, un chanfreinage de tous contacts n'est pas nécessaire ; dans ce mode de réalisation, seuls les blocs de guidage 136 et les lames situés aux extrémités sont chanfreinées.

La présente invention permet une détection des défauts de rail par les véhicules d'exploitation lors de leur exploitation normale.

En variante, le dispositif est solidarisé à un véhicule ferroviaire spécifiquement dédié non destiné au transport de personnes ou de marchandises. Il comporte un chariot auto-moteur propre à circuler de manière autonome suivant la voie en appui sur un rail unique ou les deux rails.

Ce chariot est par exemple télécommandé ou comporte des moyens de programmation pour son déplacement autonome. Il forme avec le dispositif de mesure une machine de mesure propre à l'examen de la voie.

## Revendications

1. Dispositif de détection électrique (16) destiné à être porté par un véhicule ferroviaire (10) circulant sur des rails (18) constitutifs d'une voie ferrée et permettant de déceler des défauts (19) dans au moins un rail (18), lequel dispositif de détection (16) comporte :
- un support de contact (72, 88, 100) propre à être relié mécaniquement au véhicule ferroviaire (10) ;
- au moins un contact de référence (20) et au moins un contact de mesure (22A, 22B) associés propres à être appliqués sur un rail (18), et portés par le support (72, 88,100);
- un circuit de traitement (26A, 26B) auquel sont reliés le ou chaque contact de référence (20) et le ou chaque contact de mesure (22A, 22B), propre à la mesure de l'impédance entre les contacts de référence et de mesure (20, 22A, 22B) associés,
- des moyens de positionnement du support de contact (72, 88, 100) en regard de la surface du rail suivant une direction de mesure correspondant à l'axe du rail, de sorte que le ou chaque premier contact de référence (20) et le ou chaque contact de mesure (22A, 22B) associés portent sur le même rail ;
**caractérisé en ce que**:
- il comporte au moins deux contacts de mesure (22A, 22B) décalés transversalement par rapport à la direction de mesure ; et
- le circuit de traitement (26A, 26B) comporte des moyens de mesure de l'impédance entre au moins un contact de référence (20) et chaque contact de mesure (22A, 22B).

2. Dispositif (16) selon l'une quelconque des revendications précédentes, **caractérisé en ce que** les nombres de contacts de référence (20) et de contacts de mesure (22A, 22B) sont différents.

3. Dispositif (16) selon l'une quelconque des revendications précédentes, **caractérisé en ce qu'**il comporte des moyens d'application des contacts sur le rail selon des angles d'application différents les uns des autres dans le plan transversal à la longueur du rail.

4. Dispositif (16) selon l'une quelconque des revendications précédentes, **caractérisé en ce que** le support de contact (72, 88, 100) est propre à s'appliquer sur la surface du rail et porte plusieurs contacts (20, 22A, 22B, 22C) isolés électriquement les uns des autres et chargés élastiquement à l'écart du support (72, 88, 100) portant chaque élément de contact.

5. Dispositif (16) selon la revendication 4, **caractérisé en ce que** les contacts d'un même support (88) sont reliés entre eux pour former une chaînette articulée (86), retenue à ses extrémités au support (88) et s'étendant transversalement à la direction de mesure.

6. Dispositif (16) selon la revendication 4 ou 5, **caractérisé en ce qu'**il comporte plusieurs lames adjacentes (132) isolées entre elles, chacune formant un contact, lesquelles lames sont guidées en coulissement les unes par rapport aux autres.

7. Dispositif (16) selon la revendication 4, 5 ou 6, **caractérisé en ce que** le support (88, 100) comportant une surface d'appui (90) sur un flanc latéral du rail et le dispositif comporte des moyens (112) de sollicitation latérale du support (88, 100) pour maintenir la surface d'appui (90) en contact avec le flanc latéral du rail.

8. Dispositif (16) selon l'une quelconque des revendications précédentes, **caractérisé en ce qu'**il comporte un système (28) de localisation du véhicule et des moyens de corrélation des mesures avec la position du véhicule lors de la mesure.

9. Dispositif (16) selon l'une quelconque des revendications précédentes, **caractérisé en ce qu'**il comporte des moyens (27, 30) de caractérisation des défauts à partir d'au moins deux caractéristiques d'impédance mesurées par les au moins deux contacts de mesure (22A, 22B).

10. Dispositif (16) selon l'une quelconque des revendications précédentes, **caractérisé en ce que** le ou chaque contact comporte, à chacune de ses extrémités une forme chanfreinée.

11. Véhicule (10) comportant des roues (14) propre à rouler sur la voie ferrée, **caractérisé en ce qu'**il comporte un dispositif (16) selon l'une quelconque des revendications précédentes et **en ce que** le ou chaque contact de référence (20) et le ou chaque contact de mesure (22A, 22B) associés sont disposés entre deux roues (14) immédiatement successives supportant la voiture (12).

12. Machine de mesure comportant un chariot auto-moteur automatique et/ou télécommandé propre à suivre au moins une file de rails et un dispositif (16) selon l'une quelconque des revendications 1 à 10, solidarisé au chariot auto-moteur.

13. Procédé de détection de défauts (19) portés par des rails (18) constitutifs d'une voie ferrée, **caractérisé en ce qu'**il comporte l'étape de mesure de l'impédance du rail entre au moins un contact de référence (20) et au moins deux contacts de mesure (22A, 22B) décalés transversalement par rapport à la direction principale du rail, les contacts circulant suivant la longueur du rail.

14. Procédé de détection de défauts (19) portés par des rails (18) selon la revendication 13, **caractérisé en ce que** le déplacement du dispositif le long des rails s'effectue à la vitesse normale d'exploitation d'un train,

15. Procédé de détection de défauts (19) portés par des rails (18) selon la revendication 13, **caractérisé en ce que** l'analyse des mesures fournies par les contacts de mesure (22A, 22B) s'effectue en temps réel.

## Patentansprüche

1. Elektrische Detektionsvorrichtung (16), die dazu bestimmt ist, von einem Schienenfahrzeug (10) getragen zu werden, das auf Schienen (18) fährt, die ein Eisenbahngleis bilden, und die es ermöglicht, Defekte (19) in mindestens einer Schiene (18) zu erkennen, wobei die Detektionsvorrichtung (16) aufweist:
- einen Kontaktträger (72, 88, 100), der geeignet ist, mechanisch mit dem Schienenfahrzeug (10) verbunden zu werden;
- mindestens einen zugehörigen Referenzkontakt (20) und mindestens einen Messkontakt (22A, 22B), der geeignet ist, auf einer Schiene (18) platziert zu werden und von dem Träger (72, 88, 100) getragen wird;
- eine Verarbeitungsschaltung (26A, 26B), an die der oder jeder Referenzkontakt (20) und der oder jeder Messkontakt (22A, 22B) angeschlossen sind, die zur Messung der Impedanz zwischen den zugehörigen Referenz- und Messkontakten (20, 22A, 22B) geeignet ist,
- Mittel zur Positionierung des Kontaktträgers (72, 88, 100) gegenüber der Oberfläche der Schiene in einer Messrichtung, die der Schienenachse entspricht, derart, dass der oder jeder erste Referenzkontakt (20) und der oder jeder zugehörige Messkontakt (22A, 22B) auf derselben Schiene aufliegt;
dadurch charakterisiert, dass
- sie mindestens zwei quer zur Messrichtung versetzte Messkontakte (22A, 22B) aufweist; und
- die Verarbeitungsschaltung (26A, 26B) Mittel zur Messung der Impedanz zwischen mindestens einem Referenzkontakt (20) und jedem Messkontakt (22A, 22B) aufweist.

2. Vorrichtung (16) nach einem der vorstehenden Ansprüche, **dadurch gekennzeichnet, dass** die Anzahlen der Referenzkontakte (20) und der Messkontakte (22A, 22B) unterschiedlich sind.

3. Vorrichtung (16) nach einem der vorstehenden Ansprüche, **dadurch gekennzeichnet, dass** sie Mittel zum Platzieren der Kontakte auf der Schiene unter voneinander verschiedenen Platzierungswinkeln in der Ebene quer zur Schienenlänge aufweist.

4. Vorrichtung (16) nach einem der vorstehenden Ansprüche, **dadurch gekennzeichnet, dass** der Kontaktträger (72, 88, 100) geeignet ist, auf die Oberfläche der Schiene platziert zu werden, und mehrere Kontakte (20, 22A, 22B, 22C) trägt, die elektrisch voneinander isoliert und im Abstand von dem jedes Kontaktelement tragenden Träger (72, 88, 100) elastisch belastet sind.

5. Vorrichtung (16) nach Anspruch 4, **dadurch gekennzeichnet, dass** die Kontakte desselben Trägers (88) miteinander verbunden sind, um eine Gelenkkette (86) zu bilden, die an ihren Enden auf dem Träger (88) gehalten wird und sich quer zur Messrichtung erstreckt.

6. Vorrichtung (16) nach Anspruch 4 oder 5, **dadurch gekennzeichnet, dass** sie mehrere benachbarte, voneinander isolierte, jeweils einen Kontakt bildende Kufen (132) aufweist, die gleitend zueinander geführt sind.

7. Vorrichtung (16) nach Anspruch 4, 5 oder 6, **dadurch gekennzeichnet, dass** der Träger (88, 100) eine Auflagefläche (90) an einer Seitenflanke der Schiene aufweist und die Vorrichtung Mittel (112) zum seitlichen Vorspannen des Trägers (88, 100) aufweist, um die Auflagefläche (90) in Kontakt mit der Seitenflanke der Schiene zu halten.

8. Vorrichtung (16) nach einem der vorstehenden Ansprüche, **dadurch gekennzeichnet, dass** sie ein System (28) zur Lokalisierung des Fahrzeugs und Mittel zur Korrelation der Messungen mit der Position des Fahrzeugs während der Messung aufweist.

9. Vorrichtung (16) nach einem der vorstehenden Ansprüche, **dadurch gekennzeichnet, dass** sie Mittel (27, 30) zur Charakterisierung von Defekten auf der Grundlage von mindestens zwei Impedanzcharakteristiken aufweist, die von den mindestens zwei Messkontakten (22A, 22B) gemessen werden.

10. Vorrichtung (16) nach einem der vorstehenden Ansprüche, **dadurch gekennzeichnet, dass** der oder jeder Kontakt an jedem seiner Enden eine abgeschrägte Form aufweist.

11. Fahrzeug (10) mit Rädern (14), geeignet, auf einem Eisenbahngleis zu fahren, **dadurch gekennzeichnet, dass** es eine Vorrichtung (16) gemäß einem der vorstehenden Ansprüche aufweist und dass der oder jeder Referenzkontakt (20) und der oder jeder zugehörige Messkontakt (22A, 22B) zwischen zwei unmittelbar aufeinander folgenden Rädern (14) angeordnet sind, die das Fahrzeug (12) tragen.

12. Messmaschine mit einem automatischen und/oder ferngesteuerten selbstfahrenden Wagen, der geeignet ist, mindestens einer Schienenlinie zu folgen, und einer an dem selbstfahrenden Wagen befestigen Vorrichtung (16) nach einem der Ansprüche 1 bis 10.

13. Verfahren zur Erkennung von Defekten (19), die in Schienen (18) vorhanden sind, die ein Eisenbahngleis bilden, **dadurch gekennzeichnet, dass** es den Schritt der Messung der Impedanz der Schiene zwischen mindestens einem Referenzkontakt (20) und mindestens zwei quer zur Hauptrichtung der Schiene versetzten Messkontakten (22A, 22B) aufweist, wobei die Kontakte entlang der Länge der Schiene verlaufen.

14. Verfahren zum Erkennen von Defekten (19), die in Schienen (18) vorhanden sind, nach Anspruch 13, **dadurch gekennzeichnet, dass** die Bewegung der Vorrichtung entlang der Schienen mit der normalen Betriebsgeschwindigkeit eines Zuges erfolgt,

15. Verfahren zum Erkennen von Defekten (19), die in Schienen (18) vorhanden sind, nach Anspruch 13, **dadurch gekennzeichnet, dass** die Analyse der von den Messkontakten (22A, 22B) gelieferten Messungen in Echtzeit durchgeführt wird.

## Claims

1. An electrical detection device (16) intended to be carried by a rail vehicle (10) traveling on rails (18) constituting a railway track and making it possible to detect faults (19) in at least one rail (18), said detection device (16) comprising:
- a contact support (72, 88, 100) suitable for being mechanically linked to the rail vehicle (10);
- at least one reference contact (20) and at least one corresponding measuring contact (22A, 22B) suitable for being applied to a rail (18), and carried by the support (72, 88, 100);
- a processing circuit (26A, 26B) to which the or each reference contact (20) and the or each measuring contact (22A, 22B) are connected, suitable for measuring the impedance between the corresponding reference and measuring contacts (20, 22A, 22B),
- means for positioning the contact support (72, 88, 100) facing the surface of the rail in a measurement direction corresponding to the axis of the rail, such that the or each first reference contact (20) and the or each corresponding measuring contact (22A, 22B) relate to the same rail;
**characterized in that**:
- it comprises at least two measuring contacts (22A, 22B) transversely offset relative to the measurement direction; and
- the processing circuit (26A, 26B) comprises means for measuring the impedance between at least one reference contact (20) and each measuring contact (22A, 22B).

2. The device (16) according to any one of the preceding claims, **characterized in that** the numbers of reference contacts (20) and measuring contacts (22A, 22B) are different.

3. The device (16) according to any one of the preceding claims, **characterized in that** it comprises means for applying contacts on the rail according to different application angles from one another in the plane transverse to the length of the rail.

4. The device (16) according to any one of the preceding claims, **characterized in that** the contact support (72, 88, 100) is able to be pressed on the surface of the rail and carries several contacts (20, 22A, 22B, 22C) electrically isolated from one another and elastically charged away from the support (72, 88, 100) carrying each contact element.

5. The device (16) according to claim 4, **characterized in that** the contacts of a same support (88) are connected to one another to form an articulated chain (86), retained at its ends to the support (88) and extending transversely to the measuring direction.

6. The device (16) according to claim 4 or 5, **characterized in that** it comprises several adjacent strips (132) isolated from one another, each forming a contact, said strips being guided to slide relative to one another.

7. The device (16) according to claim 4, 5 or 6, **characterized in that** the support (88, 100) comprising a bearing surface (90) on a lateral flank of the rail and the device comprises lateral stressing means (112) of the support (88, 100) to keep the bearing surface (90) in contact with the lateral flank of the rail.

8. The device (16) according to any one of the preceding claims, **characterized in that** it comprises a system (28) for locating the vehicle and means for correlating measurements with the position of the vehicle at the time of the measurement.

9. The device (16) according to any one of the preceding claims, **characterized in that** it comprises means (27, 30) for characterizing faults from at least two impedance characteristics measured by the at least two measuring contacts (22A, 22B).

10. The device (16) according to any one of the preceding claims, **characterized in that** the or each contact comprises a beveled shape at each of its ends.

11. A vehicle (10) comprising wheels (14) capable of rolling on the railway track, **characterized in that** it comprises a device (16) according to any one of the preceding claims and **in that** the or each corresponding reference (20) and/or measuring (22A, 22B) contact are arranged between two immediately successive wheels (14) supporting the car (12).

12. A measuring machine comprising an automated and/or remotely controlled self-propelled wagon able to follow at least one line of rails and a device (16) according to any one of claims 1 to 10, secured to the self-propelled wagon.

13. A method for detecting faults (19) carried by rails (18) making up a railway track, **characterized in that** it comprises the step of measuring the impedance of the rail between at least one reference contact (20) and at least two measuring contacts (22A, 22B) offset transversely relative to the main direction of the rail, the contacts circulating along the length of the rail.

14. The method for detecting faults (19) carried by rails (18) according to claim 13, **characterized in that** the movement of the device along the rails is done at the normal operating speed of a train.

15. The method for detecting faults (19) carried by rails (18) according to claim 13, **characterized in that** the analysis of the measurements provided by the measuring contacts (22A, 22B) is done in real time.
